# EUROPEAN PATENT SPECIFICATION

(11) **EP 0 545 416 B1**
(45) Date of publication and mention of the grant of the patent: **06.05.1998**
(21) Application number: 92120665.2
(22) Date of filing: 03.12.1992
(51) Int. Cl.: G11C 7/00, G06F 17/20, G06F 19/00

(54) **Recording/reproducing apparatus of a semiconductor memory that can carry out recording and reproduction simultaneously**
Aufnahme-/Wiedergabeapparat mit Halbleiterspeicher mit gleichzeitiger Aufnahme-/Wiedergabemöglichkeit
Appareil d'enregistrement et de reproduction à mémoire à semi-conducteurs pouvant simultanément enregistrer et reproduire

(30) Priority: 05.12.1991 JP 321820/91
(43) Date of publication of application: 09.06.1993
(73) Proprietor: SHARP KABUSHIKI KAISHA, Osaka-shi, Osaka-fu 545 (JP)
(72) Inventor: Ito, Shinichiro, Higashihiroshima-shi Hiroshima-ken (JP); Hayashi, Kousou, Higashihiroshima-shi Hiroshima-ken (JP)
(74) Representative: Müller, Frithjof E., Dipl.-Ing.

(56) References cited:
- US-A- 3 675 218
- US-A- 4 267 592
- US-A- 4 908 866
- US-A- 4 963 866

## Description

### BACKGROUND OF THE INVENTION

### Field of the Invention

The present invention relates to a recording/reproduction apparatus of a semiconductor memory referred to as an IC memory, and more particularly, to a recording/reproduction apparatus of a semiconductor memory that can carry out recording and reproduction simultaneously.

### Description of the Background Art

Semiconductor memories are widely used in various electronic equipment. Among these semiconductor memories, IC memory cards incorporating semiconductor memories are used as a detachable external memory of an information processing apparatus such as of personal computers and the so-called book-type electronic organizers.

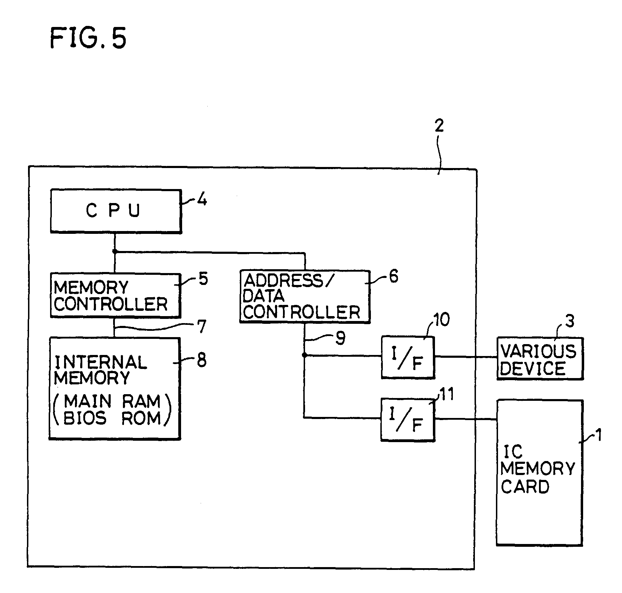

Fig. 5 is a block diagram of an audio recording/reproduction apparatus. An IC memory card 1 is used as an external memory of a personal computer 2. Various devices 3, a magnetic disc device for example, is connected to personal computer besides IC memory card 1.

Personal computer 2 includes a CPU (Central Processing Unit) 4 for carrying out the entire electrical control. CPU 4 controls a memory controller 5 and an address/data controller 6. An internal memory 8 is connected to memory controller 5 via an internal bus 7. Internal memory 8 includes a main RAM, a BIOSROM (Basic I/O System Read Only Memory), and the like. Interfaces (I/F) 10 and 11 are connected to address/data controller 6 via an extended bus 9. Various devices 3 and IC memory card 1 are connected to interfaces 10 and 11, respectively.

The data recorded on IC memory card 1 is read out via interface 11 by address/data controller 6 to be stored in internal memory 8 according to the control of memory controller 5. The data stored in internal memory 8 is read out by memory controller 5 to be recorded on IC memory card 1 via interface 11 by address/data controller 6.

As a conventional recording medium for recording/reproducing an audio signal, a magnetic tape such as a compact cassette tape and a digital audio tape is used. However, when such a tape is used, it is necessary to run the magnetic tape for detecting a desired audio signal at the time of reproduction, which is time consuming. In order to solve this problem, an audio signal recording/reproduction apparatus using an IC memory card has been proposed.

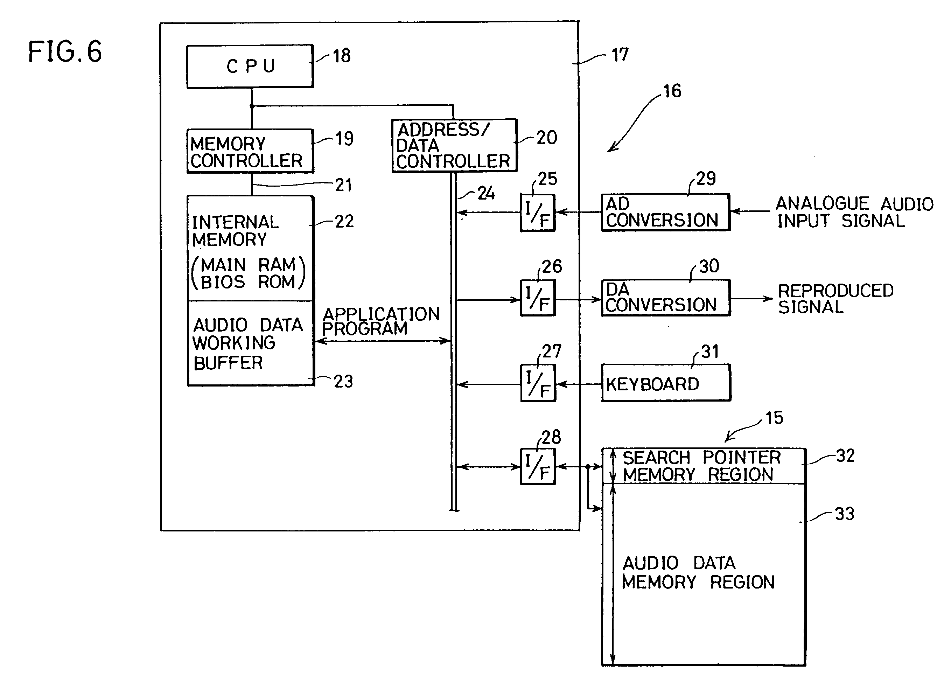

Fig. 6 is a block diagram showing schematically a structure of an audio signal recording/reproduction apparatus 16 using an IC memory card 15. IC memory card 15 is connected to a recording/reproduction control unit 17. Recording/reproduction control unit 17 includes a CPU 18 for controlling the entire apparatus. CPU 18 controls a memory controller 19 and an address/data controller 20, and audio data is recorded and reproduced in/from IC memory card 15. An internal memory 22 and an audio data working buffer 23 are connected to memory controller 19 via an internal bus 21. Internal memory 22 is implemented with a main RAM, a BIOSROM, and the like, in which an application program for the recording/reproduction of an audio data is stored. Audio data working buffer 23 is a buffer for storing audio data. Audio data is processed by accessing this buffer 23 by the application program stored in internal memory 22.

Interfaces (I/F) 25-28 are connected to address/data controller 20 via an extended bus 24. An AD (Analog-Digital) converting circuit 29, a DA (Digital-Analog) converting circuit 30, a keyboard 31, and IC memory card 15 are connected to interfaces 25-28, respectively. AD converting circuit 29 converts an analog audio input signal into a digital signal to provide the same to interface 25. Interface 25 converts the supplied digital data into a sample data of 1 byte, for example, for the purpose of storing the data into audio data working buffer 23. The converted sample data is provided to extended bus 24. DA converting circuit 30 converts digital audio data reproduced from IC memory card 15 into an analog audio data to output the same as a reproduced signal. Various operation instructions such as recording, reproduction, search point designation with respect to IC memory card 15 are entered by keyboard 31.

IC memory card includes a search pointer memory region 32 and an audio data memory region 33. Audio data of a plurality of units are stored in audio data memory region 33. Index information such as an address indicating the recording start position of each audio data is stored in search pointer memory region 32. By entering a search pointer from keyboard 31, a desired audio data can be immediately read out to be reproduced.

Because the above-described audio signal recording/reproduction apparatus 16 includes only one interface for recording/reproducing audio data with respect to IC memory card 15, reproduction of audio data of IC memory card 15 cannot be carried out during recording of an audio data. Therefore, the recording operation has to be interrupted temporarily every time a reproduction is to be carried out.

Prior art document US-A-4 908 866 discloses a speech transcribing system comprising a first transducer for converting a speech from a first individual to an electrical signal, a memory device for storing the electrical signal, and a second transducer for reproducing the speech in response to the stored electrical signal. The memory device is arranged for simultaneous recording and playback so that a second individual can transcribe a stored speech substantially simultaneously with storage of a further speech.

### SUMMARY OF THE INVENTION

An object of the present invention is to provide a recording/reproduction apparatus of a semiconductor memory highly flexible in usage. Another object of the present invention is to carry out simultaneously reproduction of data from a memory and recording of data to a memory in a recording/reproduction apparatus of a semiconductor memory. A further object of the present invention is to improve reliability of data at the time of recording in a semiconductor memory.

To solve this object the present invention provides a recording/reproduction apparatus as specified in claim 1. Preferred embodiments of the invention are described in the subclaims.

A recording/reproduction apparatus of a semiconductor memory includes especially a semiconductor memory that can store information, a read unit connected to the semiconductor memory for reading out information therefrom, a write unit connected to the semiconductor memory for writing information thereto, and a controller for controlling such that the reading unit and the writing unit operate simultaneously.

In the recording/reproduction apparatus of a semiconductor memory, control is carried out to simultaneously read and write information from and to a semiconductor memory. As a result, a recording/reproduction apparatus of a semiconductor memory highly flexible in usage can be provided.

The foregoing and other objects, features, aspects and advantages of the present invention will become more apparent from the following detailed description of the present invention when taken in conjunction with the accompanying drawings.

### BRIEF DESCRIPTION OF THE DRAWINGS

Fig. 1 is a block diagram schematically showing structure of an audio signal recording/reproduction apparatus according to an embodiment of the present invention.

Fig. 2 is a diagram showing the details of an IC memory card.

Fig. 3 is a flow chart for describing the recording operation of an audio signal recording/reproduction apparatus.

Fig. 4 is a flow chart for describing a reproduction operation of an audio signal recording/reproduction apparatus.

Fig. 5 is a block diagram showing a structure of an apparatus using an IC memory card.

Fig. 6 is a block diagram schematically showing a structure of an audio signal recording/reproduction device using an IC memory card.

### DESCRIPTION OF THE PREFERRED EMBODIMENTS

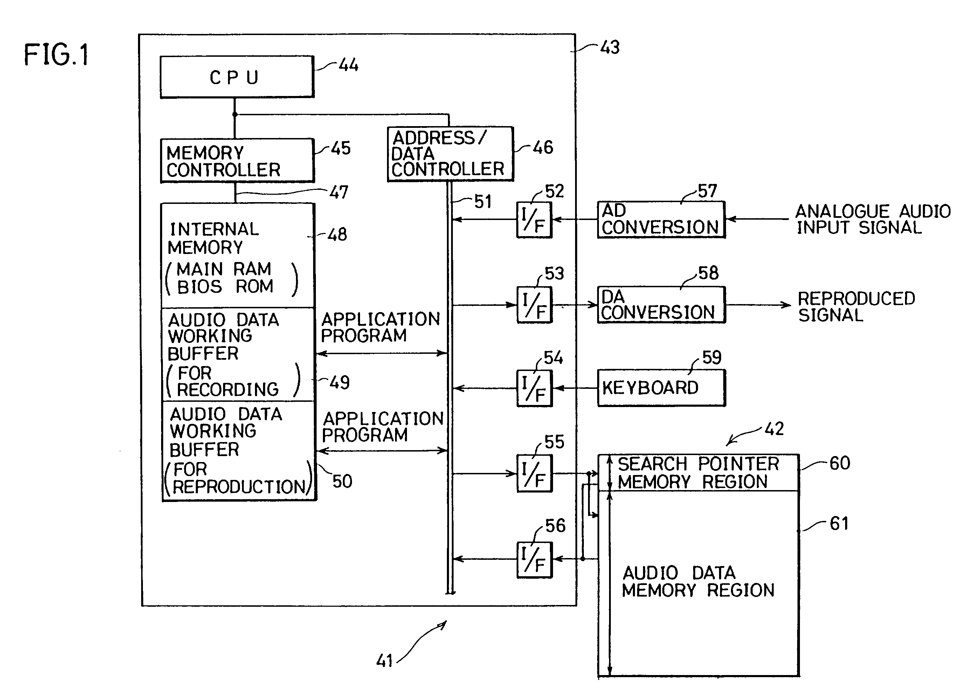

Fig. 1 is a block diagram schematically showing a structure of an audio signal recording/reproduction apparatus 41 according to an embodiment of the present invention. An IC memory card 42 incorporating a semiconductor memory is connected to a recording/reproduction control unit 43. Recording/reproduction control unit 43 is realized by the so-called personal computer. In the present embodiment,a personal computer is used as a control unit exclusively for recording/reproduction with respect to IC memory card 42 of audio signals. Therefore, recording/reproduction control unit 43 is also capable of data recording/reproduction with respect to a recording medium other than IC memory card 42.

Recording/reproduction control unit 43 includes a CPU 44 for controlling the entire apparatus. CPU 44 controls a memory controller 45 and an address/data controller 46. An internal memory 48 and audio data working buffers 49 and 50 are connected to memory controller 45 via an internal bus 47. Audio data working buffer 49 is used for recording audio data, and audio data working buffer 50 is used for reproducing audio data. Internal memory 48 is implemented with a main RAM, a BIOSROM, and the like. An application program which will be described afterwards is stored in the main RAM of internal memory 48.

Interfaces (I/F) 52-56 are connected to address/data controller 46 via an extended bus 51. An AD (Analog-Digital) converting circuit 57, a DA (Digital-Analog) converting circuit 58, a keyboard 59, and IC memory card 42 are connected to interfaces 52-56, respectively. In recording/reproduction control unit 43 of the present embodiment, interface 55 is used for recording data to IC memory card 42, and interface 56 is used for reproducing data of IC memory card 42. These interfaces 55 and 56 are controlled independent of each other.

AD converting circuit 57 converts an analog audio input signal supplied via a microphone not shown into a digital signal which is supplied to interface 52. Interface 52 converts the digital signal into a sample data of 1 byte, for example, to enter the same into audio data working buffers 49 and 50. The signal is converted into a sample data of 1 byte because it is necessary to convert the number of bits of the sample data provided from the A/D converting circuit into such that matches the extended bus since the number of bits of audio data that can be included in the extended bus is determined by the controller.

Interface 53 serves to provide the audio data stored in audio data working buffer 50 to DA converting circuit 58. DA converting circuit 58 converts the digital audio data into analog audio data to output the same as a reproduced signal. Using keyboard 59, instructions of various operations such as data recording, reproduction, and search pointer designation with respect to IC memory card 42 are entered. Keyboard 59 includes input keys such as a recording key, a reproduction key, and a search point designation key for specifying various operations.

Data is written and read out to and from IC memory card 42 via interface 55 and interface 56, respectively. If IC memory card 42 is of great capacity, the address of IC memory card 42 is switched so that CPU 44 can access the card via these interfaces 55 and 56. IC memory card 42 includes a search pointer memory region 60 and an audio data memory region 61. Audio data in a plurality of units are stored in audio data memory region 61, and index information such as a head address, i.e. of a recording start position, of each audio data is stored in search pointer memory region 60. A desired audio data can immediately be read out to be reproduced by designating a search pointer of a desired audio data by operating the aforementioned search pointer designation key via keyboard 59.

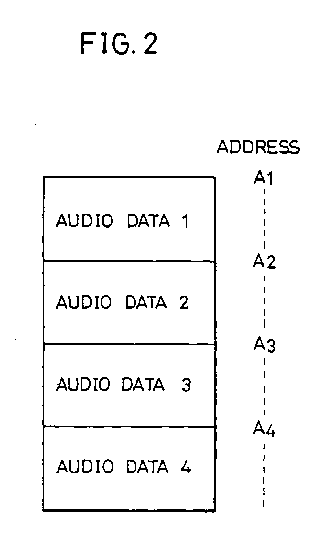

Fig. 2 shows a specific structure of an IC memory card. Assuming that the head address of audio data in each region is A1, A2, A3, and A4, the search of a desired data can be facilitated by storing these addresses as search pointers. Audio data which can be searched as one group is defined as one unit of data. The aforementioned plurality of units means that there are a plurality of units of data.

An application program for operating recording/reproduction control unit 43 is stored in internal memory 48, which is executed by CPU 44. In accordance with the application program, CPU 44 accesses audio data working buffer 49 (for recording) and audio data working buffer 50 (for reproduction) which store audio data to process audio data stored in the buffers.

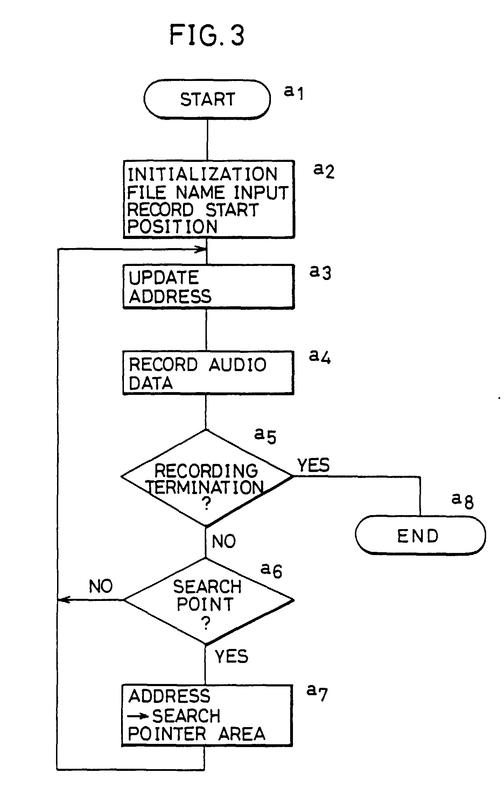

Fig. 3 is a flow chart for describing a recording operation of audio signal recording/reproduction apparatus 41. When power is supplied to the apparatus and the application program is executed, CPU 44 monitors whether there is a key input via key board 59 in accordance with the application program. When a key input instructing recording, i.e. a recording key is entered from keyboard 59, a recording operation is initiated at steps a1. At step a2, the operator carries out initial specification such as a file name input and specification of a recording start position by selecting from a menu on a screen.

At step a3, the address of the audio data memory region of IC memory card 42 is updated, and audio data is stored at step a4. An analog audio input signal is supplied to audio data working buffer 49 via AD converting circuit 57 and interface 52 to be subjected to a process such as data compression, and then recorded on IC memory card 42 via interface 55.

At step a5, if there is no key input of a recording termination at step a5, and if there is no key input of specifying a search point at step a6, the procedures of steps a3 and a4 are repeated to continue recording of audio data.

If there is a key input of record termination at step a5, the program proceeds to step a8 where the recording operation is terminated to return to the standby state for the input of other instructions.

If a search point designation key is input during the recording of audio data at step a6, the program proceeds to step a7 where the address updated at the aforementioned step a3 is stored in search pointer memory region 60 of IC memory card 42. If the operator of audio signal recording/reproduction apparatus 41 wants to mark a certain position to be detected at a later time of reproduction, the operator depresses the search point designation key during the recording operation to record the address of the position to be detected in search pointer memory region 60, whereby a detection operation can be carried out in accordance with the recorded address at the time of reproduction. Even during the recording of a search pointer, an input analog audio signal is sequentially supplied to audio data working buffer 49, so that audio data is not interrupted for recording a search pointer.

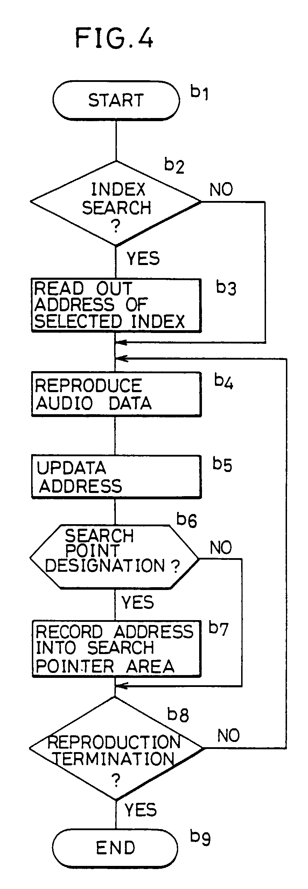

Fig. 4 is a flow chart for describing a reproduction operation of audio signal recording/reproduction apparatus 41. If a reproduction key is entered from keyboard 59 during the monitoring of a key input by CPU 44 in accordance with the application program, a reproduction operation is initiated at step b1. At step b2, if an index search command for reproducing a desired audio by specifying a search pointer is entered, the address of a selected index is read out from search pointer memory region 60 at step b3, and the program proceeds to step b4. If an index search command is not entered at step b2, the program proceeds directly to step b4.

At step b4, audio data is read out to be reproduced from the read out address or the current address. At step b5, the address is updated by 1, for example, for a subsequent reproduction of audio data.

When a search point is to be recorded newly during a reproduction operation at step b6, a search point designation key is entered from keyboard 59. This causes the currently reproduced address to be recorded in search pointer memory region 60 via I/F 55 at step b7. Here, the audio data is sent to audio data working buffer 50 via I/F 56.

At step b8, determination is made whether there is an input of a reproduction termination key or whether the reproduction operation of audio data of one unit shown in Fig. 2 has terminated or not. If the reproduction operation is to be terminated, the program proceeds to step b9 to end the operation. If the reproduction operation is not to be terminated, the program proceeds to step b4 where the reproduction of audio data of the next address is continued.

Although the above embodiment describes an example where reproduction of audio data and recording of a search point are carried out simultaneously, recording and reproduction of audio data can also be carried out simultaneously.

According to the present invention, audio data working buffers 49 and 50 are used for recording and reproduction, respectively, and interfaces 55 and 56 are individually used for recording and reproduction, respectively. Therefore, reproduction during a recording operation or recording during a reproduction operation can be carried out. Thus, flexibility at the time of data recording and reproduction with respect to IC memory card 42 is improved. Furthermore, reproducing and providing audio data immediately after recording, i.e. the so-called monitor operation can be carried out, so that the reliability of data at the time of audio data recording is improved significantly.

Although the present invention has been described in connection with a removable IC memory card 42, the present invention is applicable to a semiconductor memory provided in a fixed manner in an electronic equipment.

Although the present invention has been described and illustrated in detail, it is clearly understood that the same is by way of illustration and example only and is not to be taken by way of limitation, the scope of the present invention being limited only by the terms of the appended claims.

## Claims

1. A recording/reproduction apparatus (43) comprising:
a semiconductor memory (42) for storing recorded information,
recording means (49) connected to said semiconductor memory (42) for recording said information into said semiconductor memory (42),
reproduction means (50) connected to said semiconductor memory (42) for reproducing said information stored in said semiconductor memory (42),
a first interface (55) connected to said recording means for recording said information into said semiconductor memory (42), and
a second interface (56) connected to said reproduction means for reproducing said information stored in said semiconductor memory (42),
**characterized** by further comprising:
control means (44, 45, 46) for controlling independently said recording means (49, 55) and said reproduction means (50, 56),
whereby said recording means (49, 55) and said reproduction means (50, 56) are operated simultaneously.

2. The recording/reproduction apparatus (43) of a semiconductor memory (42) according to claim 1, **characterized** by further comprising means (52, 57) connected to said recording means (49, 55) for receiving externally applied information.

3. The recording/reproduction apparatus (43) of a semiconductor memory (42) according to claim 1 or 2, **characterized** by further comprising means (53, 58) connected to said reproduction means (50, 56) for providing information to an external apparatus.

4. The recording/reproduction apparatus (43) of a semiconductor memory according to any one of claim 1 to 3, **characterised** in that said semiconductor memory (42) comprises a first region (61) for storing a predetermined first data, and a second region (60) for storing a second data corresponding to the address of said stored first data,
said first (61) and second (60) regions being connected to said recording means (49, 55) and said reproduction means (50, 56), respectively.

5. The recording/reproduction apparatus (43) of a semiconductor memory (42) according to any one of claims 1 to 4, **characterized** in that said semiconductor memory (42) is detachable from said apparatus (43).

6. The recording/reproduction apparatus (43) of a semiconductor memory according to claim 4, **characterized** by further comprising storing means for storing said second data into the second region (60) of said semiconductor memory (42) during operation of said recording means (49, 55) and said reproduction means (50, 56).

## Patentansprüche

1. Aufzeichnungs/Wiedergabegerät (43), umfassend:
einen Halbleiterspeicher (42) zum Speichern aufgezeichneter Information,
eine mit dem Halbleiterspeicher (42) verbundene Aufzeichnungseinrichtung (49) zum Aufzeichnen der Information in dem Halbleiterspeicher (42),
eine mit dem Halbleiterspeicher (42) verbundene Wiedergabeeinrichtung (50) zum Wiedergeben der in dem Halbleiterspeicher (42) gespeicherten Information,
eine erste Schnittstelle (55), die mit der Aufzeichnungseinrichtung zum Aufzeichnen der Information in dem Halbleiterspeicher (42) verbunden ist, und
eine zweite Schnittstelle (56), die mit der Wiedergabeeinrichtung zum Wiedergeben der in dem Halbleiterspeicher (42) gespeicherten Information verbunden ist,
gekennzeichnet durch
eine Steuereinrichtung (44, 45, 46) zum unabhängigen Steuern der Aufzeichnungseinrichtung (49, 55) und der Wiedergabeeinrichtung (50, 56),
wodurch die Aufzeichnungseinrichtung (49, 55) und die Wiedergabeeinrichtung (50, 56) gleichzeitig betrieben sind.

2. Aufzeichnungs/Wiedergabegerät (43) eines Halbleiterspeichers (42) nach Patentanspruch 1, gekennzeichnet durch weiterhin eine mit der Aufzeichnungseinrichtung (49, 55) verbundene Einrichtung (52, 57) zum Empfangen extern angelegter Information.

3. Aufzeichnungs/Wiedergabegerät (43) eines Halbleiterspeichers (42) nach Anspruch 1 oder 2, gekennzeichnet durch eine mit der Wiedergabeeinrichtung (50, 56) verbundene Einrichtung (53, 58) zum Liefern von Information zu einem externen Gerät.

4. Aufzeichnungs/Wiedergabegerät (43) eines Halbleiterspeichers nach einem der Ansprüche 1 bis 3, dadurch gekennzeichnet, daß der Halbleiterspeicher (42) einen ersten Bereich (61) zum Speichern vorbestimmter erster Daten und einen zweiten Bereich (60) zum Speichern zweiter Daten, die der Adresse der gespeicherten ersten Daten entsprechen, aufweist,
wobei der erste (61) und der zweite (60) Bereich jeweils mit der Aufzeichnungseinrichtung (49, 55) bzw. der Wiedergabeeinrichtung (50, 56) verbunden sind.

5. Aufzeichnungs/Wiedergabegerät (43) eines Halbleiterspeichers (42) gemäß einem der Ansprüche 1 bis 4, dadurch gekennzeichnet, daß der Halbleiterspeicher (42) von dem Gerät (43) lösbar ist.

6. Aufzeichnungs/Wiedergabegerät (43) eines Halbleiterspeichers nach Anspruch 4, gekennzeichnet durch eine Speichereinrichtung zum Speichern der zweiten Daten in dem zweiten Bereich (60) des Halbleiterspeichers (42) während eines Betriebes der Aufzeichnungseinrichtung (49, 55) und der Wiedergabeeinrichtung (50, 56).

## Revendications

1. Dispositif d'enregistrement/reproduction (43), comprenant:
une mémoire (42) à semi-conducteurs servant à stocker des informations enregistrées;
un moyen d'enregistrement connecté à ladite mémoire (42) à semi-conducteurs pour enregistrer lesdites informations dans ladite mémoire (42) à semi-conducteurs,
un moyen de reproduction connecté à ladite mémoire (42) à semi-conducteurs pour reproduire lesdites informations stockées dans ladite mémoire (42) à semi-conducteurs;
une première interface (55) connectée audit moyen d'enregistrement pour enregistrer lesdites informations dans ladite mémoire (42) à semi-conducteurs, et
une deuxième interface (56) connectée audit moyen de reproduction pour reproduire lesdites informations stockées dans ladite mémoire (42) à semi-conducteurs,
**caractérisé** en ce qu'il comprend en outre:
des moyens de commande (44, 45, 46) servant à commander de manière indépendante lesdits moyens d'enregistrement (49, 55) et lesdits moyens de reproduction (50, 56),
grâce à quoi lesdits moyens d'enregistrement (49, 55) et lesdits moyens de reproduction (50, 56) fonctionnent simultanément.

2. Dispositif d'enregistrement/reproduction (43) d'une mémoire (42) à semi-conducteurs selon la revendication 1, **caractérisé** en ce qu'il comprend en outre des moyens (52, 57) connectés auxdits moyens d'enregistrement (49, 55) pour recevoir des informations appliquées de l'extérieur.

3. Dispositif d'enregistrement/reproduction (43) d'une mémoire (42) à semi-conducteurs selon la revendication 1 ou 2, **caractérisé** en ce qu'il comprend en outre des moyens (53, 58) connectés auxdits moyens de reproduction (50, 56) pour fournir des informations à un dispositif extérieur.

4. Dispositif d'enregistrement/reproduction (43) d'une mémoire à semi-conducteurs selon l'une quelconque des revendications 1 à 3, **caractérisé** en ce que ladite mémoire (42) à semi-conducteurs comporte une première région (61) servant à stocker des premières données prédéterminées, et une deuxième région (60) servant à stocker des deuxièmes données correspondant à l'adresse desdites premières données stockées,
lesdites première (61) et deuxième (60) régions étant respectivement connectées auxdits moyens d'enregistrement (49, 55) et auxdits moyens de reproduction (50, 56).

5. Dispositif d'enregistrement/reproduction (43) d'une mémoire (42) à semi-conducteurs selon l'une quelconque des revendications 1 à 4, **caractérisé** en ce que ladite mémoire (42) à semi-conducteurs est séparable dudit dispositif (43).

6. Dispositif d'enregistrement/reproduction (43) d'une mémoire à semi-conducteurs selon la revendication 4, **caractérisé** en ce qu'il comprend en outre un moyen de stockage servant à stocker lesdites deuxièmes données dans la deuxième région (60) de ladite mémoire (42) à semi-conducteurs pendant le fonctionnement desdits moyens d'enregistrement (49, 55) et desdits moyens de reproduction (50, 56).
